# EUROPEAN PATENT APPLICATION

(11) **EP 3 220 105 A1**
(43) Date of publication of application: **20.09.2017**
(21) Application number: 17160903.5
(22) Date of filing: 14.03.2017
(51) Int. Cl.: G01D 5/14, G01D 5/244

(54) **A MAGNETIC POSITION SENSOR**

(30) Priority: 14.03.2016 GB 201604297
(71) Applicant: Reventec Limited, Salisbury, Wiltshire SP5 3HU (GB)
(72) Inventor: CAWTE, Andrew, Salisbury, Wiltshire SP5 3HU (GB); MEECH, Neville, Salisbury, Wiltshire SP5 3HU (GB)
(74) Representative: ip21 Ltd

(57) **Abstract**

A method of sensing a magnetic field of a magnet located at a first position using a magnetic position sensor, comprising the steps of:
• Subjecting said magnetic position sensor to a pulsed reset magnetic field to align the magnetic field of the sensor to a pre-set value and orientation; and
• Providing an indication of said magnetic field of a magnet when said reset magnetic field was not present; [replacing / resetting the information for the positional measurement of the magnet with information for the reset pulse].

## Description

### Field of the Invention

The invention relates to a magnetic sensor and in particular to a magnetic position sensor.

### Background of the Invention

It is known that magnetic position sensors are used in a wide variety of applications where a reliable, non-contact sensing method is required. Wherever a mechanical assembly exists in which one component is able to move relative to another, by attaching a permanent magnet to one of the components, it is possible to use a magnetic sensor to determine their relative positions at any given time.

Thus, there is no physical contact between the magnetic and the sensor device. Thus there is no mechanical wear of the sensor, there can be a significant distance between the two components. Furthermore, it is also possible to sense through certain materials, so the position of an otherwise inaccessible component can be measured.

However, it is also known that certain types of magnetic sensors exhibit a memory effect; this effect is when the sensor output depends not only on the applied magnetic field at the time a measurement is taken, but also on the magnetic fields to which they have been subjected in the past.

E.g. an example of a memory effect is similar to a compass needle that possesses friction at its bearing; whereby the needle points accurately in the direction of a magnetic field if the applied field is strong enough. However, the needle may also turn part way from its previous position if the applied magnetic field is weak.

Many such sensors also only report the direction, and not the strength, of the applied magnetic field.

Therefore, the disadvantages of the use of such magnetic position sensors are:
- It is impossible to determine from the output of a sensor, whether a magnetic field is actually still present or not. The signal indicates the direction of the most recently applied field, even though that field may have been removed some time ago;
- Where the applied magnetic field is weak, the sensor may exhibit considerable hysteresis. The output becomes an inaccurate measure of the field direction, which limits the maximum separation that can exist between the sensor and the magnet;
- In certain safety critical applications, it is essential to be able to detect abnormal conditions, such as a component breaking or going outside the range of movement which is permitted in normal operation. In this case it is imperative that the signal for "no magnet in range" is uniquely identifiable and distinct from any signal likely to be encountered in normal service; and
- Therefore it is a known problem that the output of known magnetic field sensors always depends on, to a greater or lesser extent, both the position of the monitored magnet and the magnetic history to which the magnetic field sensor has been subjected.

It is an object of the invention to provide a magnetic position sensor that addresses the above problems.

### Summary of the Invention

In a first broad independent aspect the invention provides a method of sensing a magnetic field of a magnet located at a first position using a magnetic position sensor, comprising the steps off:
- Subjecting said magnetic position sensor to a pulsed reset magnetic field to align the magnetic field of the sensor to a pre-set value and orientation;
- Providing an indication of said magnetic field of a magnet when said reset magnetic field was not present; and
- Providing an indication of said first position; wherein said magnetic field of a magnet is strong relative to the minimum magnetic field strength which facilitates the accurate sensing of said magnetic field from a magnet.

This configuration is advantageous because it provides a method of sensing two magnetic fields to accurately determine the position of sensed magnet. This configuration senses and provides an indication of the magnetic field of the magnet when the reset magnetic field is not present. The sensor will not provide an indication of the magnetic field of the magnet when the reset magnetic field is present. The sensor will then provide a subsequent indication of the magnetic field of the magnet when the reset magnetic field is no longer present. This subsequent acquisition of the indication of the magnetic field of the magnet, over writes any previous information indicative the magnetic field of the magnet; thus preventing the sensor from exhibiting an undesirable memory effect [also known as a magnetic history effect]. Such a memory effect could result in the inaccurate sensing of the magnet's field orientation and thus its associated position.

This configuration is further advantageous because it accurately determines the accurate positioning of the sensed magnet via its strong magnetic field, irrespective of the sensing of the discontinuous magnetic field.

Preferably, a method of sensing a magnetic field of a magnet located at a first position using a magnetic position sensor further comprising the step of providing an indication of a second position; wherein said magnetic field of a magnet is weak relative to the minimum magnetic field strength which facilitates the accurate sensing of said magnetic field from a magnet.

This configuration is advantageous because it determines the positioning of the sensed magnet via its weak magnetic field. The second position is measured more accurately than it could otherwise be measured, because the discontinuous field has erased the magnetic history of the sensor. Thus, the repeatable inaccurate indications of the sensed magnet would indicate a second position which does not depend upon the historical movements of the magnet. The sensing of the weaker magnetic field can extend the useful range, which the sensor can operate, for a given magnet type. This increase of the useful range may be in the form of locating the magnet in remote locations, which are otherwise inaccessible. Or alternatively, the weaker field may be due to the sensor cooperating with magnets types which have weaker field strengths.

Preferably, a method of sensing a magnetic field of a magnet located at a first position using a magnetic position sensor further comprising the step of providing an indication of a third position; wherein said magnetic field of a magnet is very weak or not present relative to the minimum magnetic field strength which facilitates the accurate sensing of said magnetic field from a magnet.

This configuration is advantageous because it determines if the positioning of the sensed magnet is out of range of the sensor, or alternatively if a fault has developed within the sensor. Thus, the discontinuous magnetic field would be the last magnetic field sensed. Therefore, the sensor would indicate a third position which is not expected or permitted in normal action and can therefore be identified as an error condition.

Preferably a method of sensing a magnetic field of a magnet located at a first position via a magnetic position sensor further comprising the step of providing an indication of said reset magnetic field when said reset magnetic field is present; wherein said sensor senses a combined magnetic field comprising said magnetic field from a magnet and said reset magnetic field.

This configuration is advantageous because it provides an indication of the reset magnetic field, which is dependent upon the direction of the magnetic field of the magnet being continuously variable, and the relative strengths of the magnetic field of the magnet and the reset magnetic field. Thus, the sensor will indicate the most recent field that was strong enough to influence it. Therefore, this configuration also provides a means of verifying the generation of the reset pulse and providing a check on the integrity of the system employed by the process. However, the direction of the sensed reset magnetic field may vary due to the relative strengths of the current magnetic field of the magnet and the reset magnetic field. Therefore, this process may be programmed with prior information of what direction to expect the sensor to indicate, which is dependent upon the known possible range of positions, in normal use, of the magnet, along with the known strength of the current magnetic field of the magnet and the known strength of the reset magnetic field.

Preferably, an apparatus for sensing a magnetic field of a magnet located at a first position using a magnetic position sensor comprising said reset magnetic field which operates in accordance with any of the above; wherein said reset magnetic field for resetting said sensor is provided by communicating a pulsed electrical current to an electromagnetic means; whereby said electromagnetic means is in proximity to said magnetic position sensor.
This configuration enables the generation of a reset pulse via an electromagnetic means, which is then sensed by the sensor.
Preferably, said reset magnetic field is provided by a time discontinuous electrical current to said electromagnetic means.
This configuration enables the reset magnetic field to be generated by any form or sequence of time discontinuous electrical waveforms or pulses being communicated to the electromagnetic means.

Preferably, said electromagnet means comprises one or more conductive elements are arranged in proximity to said sensor.

Preferably, said conductive elements are arranged on and/or within a printed circuit board.

This configuration enables the forming of an electromagnet device using components of printed circuit board or one or more turns of electrically conductive wire arranged in proximity to the sensor, which in use, generates the discontinuous reset magnetic field.

Preferably, said one or more conductive elements are located adjacent to said magnetic sensor.

This configuration enables the conductive elements of the electromagnet to be positioned close to the sensor. Therefore, in use, the small distance between them would enable the resulting magnetic field to be sensed by the sensor.

In a second broad independent aspect, the invention provides a magnetic position sensor comprising:
- a sensing means for sensing a magnetic field of a magnet located at a first position,
- said sensing means is suitable for sensing a pulsed reset magnetic field not originating from said magnet; and
- an indicating means for providing an indication of said magnetic field of a magnet when said reset magnetic field was not present,
- wherein said indicating means is suitable for providing an indication of said reset magnetic field when said reset magnetic field is present; wherein said sensor senses a combined magnetic field comprising said magnetic field from a magnet and said reset magnetic field.

This configuration is advantageous because it provides a magnetic position sensing device, which in use, senses two magnetic fields to accurately determine the position of sensed magnet. This configuration senses and provides an indication of the magnetic field of the magnet when the reset magnetic field is not present. The sensor will not provide an indication of the magnetic field of the magnet when the reset magnetic field is present. The sensor will then provide a subsequent indication of the magnetic field of the magnet when the reset magnetic field is no longer present. This subsequent acquisition of the indication of the magnetic field of the magnet, over writes any previous information indicative the magnetic field of the magnet; thus preventing the sensor from exhibiting an undesirable memory effect [also known as a magnetic history effect]. Such a memory effect could result in the inaccurate sensing of the magnet's field orientation and thus its associated position.

This configuration is further advantageous because it provides an indication of the reset magnetic field, when the reset magnetic field is stronger than the current magnetic field of the magnet. Thus the sensor will indicate the most recent field that was strong enough to influence it.

Preferably, a magnetic position sensor further comprises a means of providing one or more measurement cycles, whereby in use, a measurement cycle comprises said indication of reset magnetic field which is arranged subsequent to said indication of said magnetic field of a magnet, which in use, facilitates a resetting of said information of said magnetic field from said magnet of said measurement cycle.

This configuration enables the repeatable monitoring of the historical movements of the magnet, whereby the magnetic history of the magnet is consistent from one measurement cycle to the next measurement cycle. Therefore, each current measurement cycle is reset and thus prevents the magnetic history of the current measurement cycle from exhibiting a memory effect on the positional indication of the sensed magnet provided by the next measurement cycle.

Preferably, a magnetic position sensor further comprising a metallic pad, which in use communicates a pulsed reset electrical current and thereby generating a pulsed reset magnetic field.

This configuration enables the metallic pad [e.g. copper or aluminium] to be positioned close to the sensor, or incorporated within the packaging/body of the sensor. Therefore, in use, the small distance between them would enable the resulting magnetic field to be sensed by the sensor.

### A Brief Description of the Figures

Figure 1 shows a circuit diagram for the controller circuit comprising two sensor channels.
Figure 2 shows a circuit diagram for the voltage feedback circuit for a controller device.
Figure 3 shows a circuit diagram for the power regulation/control for a controller device.
Figure 4 shows a circuit diagram for the first channel.
Figure 5 shows a circuit diagram for the second channel.
Figure 6 shows a circuit diagram for the sensor board.
Figures 7A and 7B are schematic views of a physical layout of the magnetic position sensor.

### A Detailed Description of the Figures

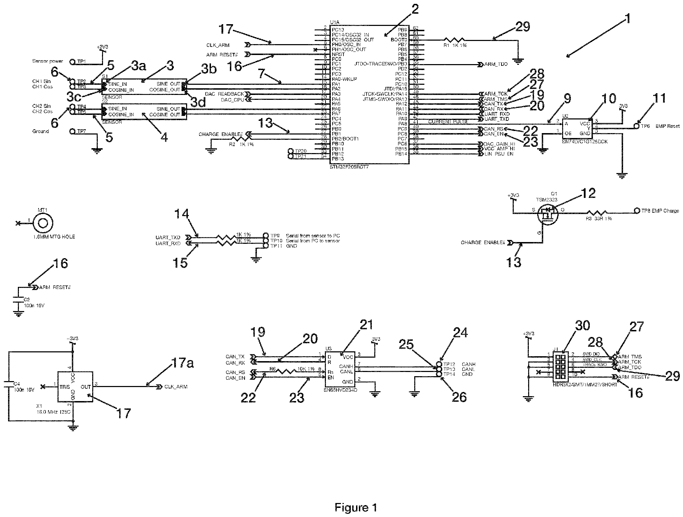

Figure 1 shows a controller circuit diagram for monitoring a magnetic position sensor, which is generally indicated by 1.

The apparatus comprises both digital and analogue components which form the circuit for driving and monitoring of the magnetic sensors. These components are an ARM(TM) based control processor unit (CPU) 2 which receives electrical input signals from two amplifiers 3 and 4. These amplifiers boost the electrical signals from each of two separate identical magnetic sensor boards 120.

The two amplifiers are identical to each other whereby each amplifier incorporates a SINE_IN input 3a, a SINE_OUT output 3b, a COSINE_IN input 3c and a COSINE_OUT output 3d.

Both the SINE_IN and COSINE_IN inputs are electrically connected, via conductive tracks 5 (i.e. copper tracks) to dedicated SINE_IN and COSINE_IN test points 6.

For sensor 1, both the SINE_OUTPUT and COSINE_OUT outputs are electrically connected via conductive tracks 7 (i.e. again copper tracks), to dedicated input ports PA1 and PA2 of CPU 2. For sensor 2 both the SINE_OUTPUT and COSINE_OUT outputs are electrically connected by via conductive tracks to dedicated input ports PA6 and PA7 of CPU 2.

A control signal (CURRENT PULSE) is electrically connected from PA 8 of CPU 2 to input A of the buffer device 10, via conductive track 9. The digital buffer device is then electrically connected to a test point EMP RESET 11.

A "P" channel MOSFET device 12 is employed to function as an "EMP CHARGE" switch, which is activated by a CHARGE_ENABLE signal, which is electrically connected from a "CHARGE_ENABLE" output PB1 of CPU 2.

A serial data connection port UART_TXD 14 is electrically connected to PA9 of CPU 2, to provide a serial data communication from a sensor to a computer.

A serial data communication port UART_RXD 15 is electrically connected to PA10 of CPU2, to provide a serial data communication from a computer to a sensor.

An ARM_RESET 16 is electrically connected to the NRST port of CPU 2 to provide a reset signal to the CPU.

CLK-ARM 17 is electrically connected to the PH0/OSC_IN port of the CPU to provide a 16 MHz clock signal.

Both CAN_TX 19 and CAN_RX 20 are electrically connected to PA12 and PA11 of the CPU 2 respectively. Both CAN_RS 22 and CAN_EN 23 are electrically connected to PC9 and PC8 of CPU 2 respectively. CAN_TX 19, CAN_RX 20, CAN_RS 22 and CAN_EN 23 provide a CANBUS communication means to and from a CANBUS communication driver device 21 to the CPU2.

CAN_H24, CAN_L25 and GND26 are electrically connected from the CANBUS driver 21, to test points TP12, 13 and 14 - (24, 25 and 26 respectively).

ARM-TMS27 is electrically connected from PA13 of the CPU 2 to an electrical header device 30. These pins provide the connection to a programming device, which is employed to load the software onto the CPU as part of the manufacturing and/or development processes.

ARM-TCK28 is electrically connected from PA14 of the CPU 2 to an electrical header device 30.

ARM_TDO 29 is electrically connected from JTDO-TRACEWO/PB3 to an electrical header device 30.

ARM_RESET is electrically connected from NRST of CPU 2 to an electrical header device 30.

CLK_ARM 17a is electrically connected from the 'OUT' of a 16 Megahertz (MHz) frequency generating device 17, to the PH0/OSC_IN of CPU 2.

In use, a sensor comprising the 2 channel controller circuit enables its sensing range to be extended beyond that which could be achieved with by employing a single channel. The system/controller is configured so that whichever sensor channel is in range of the magnet at any given time, the channel within range will be the one that is used and the other channel will be ignored. The 'reset' field is used to make it apparent when the magnet has gone out of range of one of the sensors.

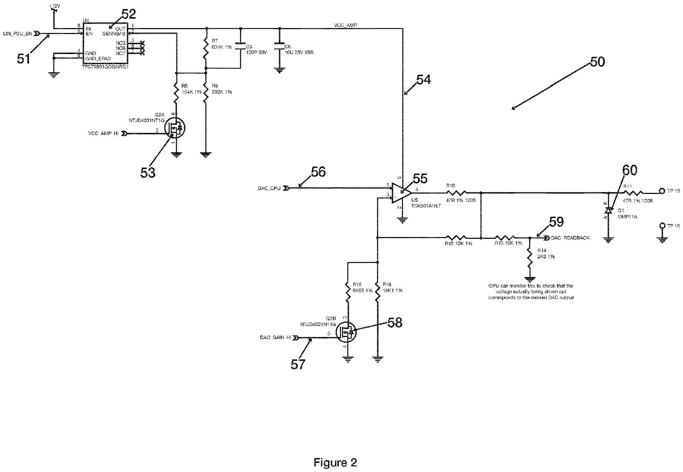

Figure 2 shows a test circuit for monitoring the actual voltage driven output that corresponds to the desired digital analogue conversion (DAC) output of the CPU device 2 (shown in Figure 1) and is generally indicated by 50.

A LIN_PSU_EN 51 is electrically connected from PB14 of the CPU 2 to a voltage regulator device 52.

The VC_AMP_HI, is electrically connected from PB15 of the CPU 2 to a "N" channel "MOSFET" switch 53 which in turn switches the sense/FB of the voltage regulator 52, A VCC_AMP 54 is connected from "OUT" of voltage regulator 52 to power a linear operational amplifier (OP AMP) device 55.

A DAC_CPU 56 is electrically connected from PA4 of CPU2 to a positive input of the OP AMP device 55.

A DAC_GAIN_HI 57 is electrically connected from PC6 of the CPU to a "N" channel MOSFET switch 58 which in turn switches an input to the negative input of the OP-AMP device 55.

A DAC_READBACK 59 is electrically connected from the output of the OP AMP device to PA3 of the CPU device 2. The output of op-amp 55 is also electrically connected to test point 15 and its voltage is clamped to a determined maximum voltage by a Zener diode 60.

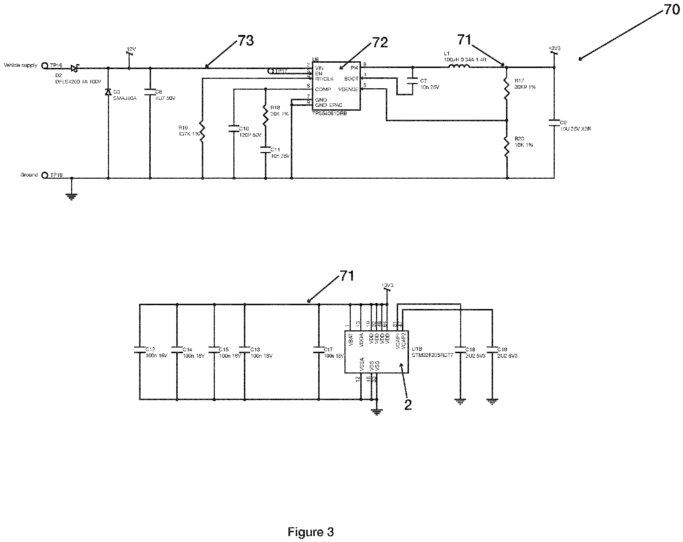

Figure 3 shows a power supply circuit diagram which powers the 3.3 volt power rail 71 and is generally indicated by 70.

The 3.3 volt DC power supply 71 is provided by a voltage switching regulator 72, which is initially supplied by a 12 volt DC power supply 73.

The power rail 71 is also electrically connected to the CPU device 2.

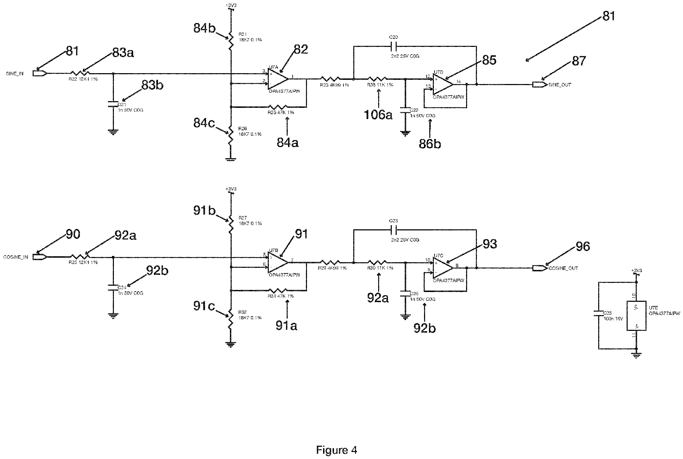

Figure 4 shows a circuit diagram for a first sensor for monitoring a magnetic position sensor and is generally indicated by 81.

A SINE_IN 81 is electrically connected to an OP AMP 82 via a resistor-capacitor (RC) filter 83a and 83b.

OP AMP 82 is configured as a negative feedback amplifier to provide an output with a gain of 6 via resistors 84a, 84b and 84c. Resistors 84c, 84b, 86a, 86b, OP AMP 85 and capacitor C20 are all connected to form a low-pass filter circuit. This low-pass filter improves the overall signal-to-noise ratio for the whole system, thereby removing frequencies that are greater than 0.5 times the rate at which measurements are taken. Thus, the low-pass filter prevents any aliasing [according to Nyquist's sampling theorem].

The output is electrically connected to a second OP AMP 85 which is configured as a voltage follower device (i.e. a unity gain buffer) 85 via second RC filter 86a and 86b.

The output of the filter device 85 provides a SINE_OUT 87 which is electrically connected to PA1 of the CPU 2.

A COSINE_IN 90 is electrically connected to an OP AMP 91 via a resistor-capacitor (RC) filter 92a and 92b.

OP AMP 91 is configured as a negative feedback amplifier to provide an output with a gain of 6 via resistors 92a, 92b and 92c. Resistors 92c, 91 b, 92a, 92b, 83 and capacitor C23 are all connected to form a low-pass filter circuit. This low-pass filter improves the overall signal-to-noise ratio for the whole system, thereby removing frequencies that are greater than 0.5 times the rate at which measurements are taken. Thus, the low-pass filter prevents any aliasing [according to Nyquist's sampling theorem]

The output is electrically connected to a second OP AMP 93, which is configured as a voltage follower device (i.e. a unity gain buffer) 93 via a second RC filter 92a and 92b.

The output of the filter device 93 provides a COSINE_OUT 94 which is electrically connected to PA2 of CPU 2.

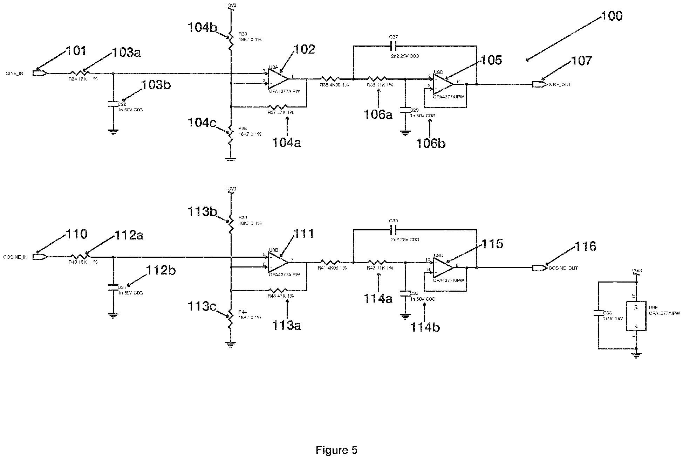

Figure 5 shows a circuit diagram for a second sensor for monitoring a magnetic position sensor and is generally indicated by 100.

A SINE_IN 101 is electrically connected to an OP AMP 102 via a resistor-capacitor (RC) filter 103a and 103b.

OP AMP 102 is configured as a negative feedback amplifier to provide an output with a gain of 6 via resistors 104a, 104b and 104c. Resistors 104c, 104b, 106a, 106b, 105 and capacitor C27 are all connected to form a low-pass filter circuit. This low-pass filter improves the overall signal-to-noise ratio for the whole system, thereby removing frequencies that are greater than 0.5 times the rate at which measurements are taken. Thus, the low-pass filter prevents any aliasing [according to Nyquist's sampling theorem].

The output of the filter device 105 provides a SINE_OUT 107 which is electrically connected to PA6 of the CPU 2.

A COSINE_IN 110 is electrically connected to an OP AMP 111 via a resistor-capacitor (RC) filter 112a and 112b.

OP AMP 111 is configured as a negative feedback amplifier to provide an output with a gain of 6 via resistors 113a, 113b and 113c. Resistors 113c, 113b, 114a, 114b, 115 and capacitor C30 are all connected to form a low-pass filter circuit. This low-pass filter improves the overall signal-to-noise ratio for the whole system, thereby removing frequencies that are greater than 0.5 times the rate at which measurements are taken. Thus, the low-pass filter prevents any aliasing [according to Nyquist's sampling theorem].

The output is electrically connected to a second OP AMP 115, which is configured as a voltage follower device (i.e. a unity gain buffer) 115 via a second RC filter 114a and 114b.

The output of the filter device 115 provides a COSINE_OUT 116 which is electrically connected to PA7 of the CPU 2.

Both the SINE_IN and COSINE_IN, and SINE_OUT and COSINE_OUT channels are identical to the circuit shown in Figure 4.

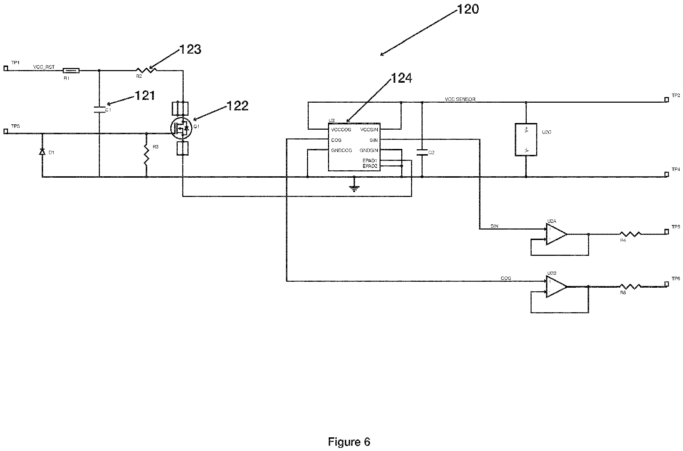

Figure 6 shows a circuit diagram for the sensor circuit board and is generally indicated by 120.

In use, Capacitor C1 121 is charged-up in between positional measurements of a magnet, and acts as an energy storage device. After each positional measurement, transistor Q1 122 is turned on by the controller, and C1 121 discharges rapidly through resistor R2 123 and Q1 122. This rapid discharge results in a large current, the value of which is regulated by the value of R2. This current passes through the metallic pad in the base of device U3 [via EPAD1], and the magnetic field which results from this movement of current is the required reset magnetic field.

Once the energy within C1 121 has substantially discharged, Q1 122 is then turned off again, and C1 is then subsequently recharged so that it is ready for the next measurement cycle.

In use, the magnetic position sensor is subjected to a strong second magnetic field, in a known direction in between measurements being taken in regards to the initial magnetic field, created by a magnet located at the required measurement position.
The effect of this second magnet field is to 'reset' the direction output of the sensor to a known default, thereby effectively 'erasing' its magnetic history. Once the re-setting' field is removed, the sensor is once again subjected only to the applied field from the permanent magnet, and a measurement of the output from the sensor can be taken.
The result of this measurement can then be classified in one of three ways:
- If the applied field from the permanent magnet is strong, then the sensor indicates its direction accurately, just as before. I.e. Strong with respect to the minimum field strength that the sensor is capable of measuring accurately.
- If the applied field from the permanent magnet is weak, then the sensor indicates its direction in a way which may not be accurate, but is still repeatable and does not now depend on historical movements of the magnet. 'Resetting' the sensor in between measurements dramatically reduces the effect of hysteresis, therefore making the sensor more accurate, more sensitive and results in an increase in the useful range over which the sensor can operate for a given magnet. This increase in useful range may result in extending the range of the sensor which enables it to cooperate with a magnet is located in remote locations which are otherwise inaccessible. Or, alternatively the sensor may cooperate with other magnet types, which have weaker field strengths. The loss of absolute accuracy can be compensated for in software (or otherwise). I.e. weak with respect to the minimum field strength that the sensor is capable of measuring accurately.
- If there is little or no applied field, such as will happen if the magnet goes out of range, then the output from the sensor will indicate the direction of the last observed field which is the re-setting field. E.g. the output of the sensor is still consistent with the orientation of the reset field. Provided this is chosen to be a direction which is not expected or permitted in normal operation, it can be identified as an error condition and appropriate action taken. The provision of the reset field or pulse between measurements, results in the magnetic history of the sensor being limited to the time when the measurement of magnetic field of the magnet was taken.

The measurement cycle for the sensor comprises the sensed magnetic field of the magnet, which is then followed by the sensed magnetic field of the reset pulse. Therefore the use of one or more measurement cycles enables the repeatable monitoring of the historical movements of the magnet, whereby the magnetic history of the magnet is limited to and consistent from one measurement cycle to the next measurement cycle.
The provision of the reset field or pulse between measurements cycles, results in the magnetic history of the sensor being limited to the time when the measurement of magnetic field of the magnet was taken. Therefore preventing the magnetic history of the current measurement cycle from exhibiting a memory effect on the positional indication of the sensed magnet provided by the next measurement cycle.

In an embodiment of the invention:
- The magnetic field sensor is packaged by its manufacturer as a discrete component which may be mounted to a printed circuit board (PCB) by soldering.
- The re-setting field is generated by passing an electric current through a conductive trace or traces which are fabricated on the PCB and which run under the sensor.
- When current is applied, these traces act as an electromagnet, which has the effect of applying a magnetic field to the sensor.
- The direction of this field depends on the direction of current flow and the physical layout of the PCB traces.

In an alternative embodiment of the invention:
- The magnetic field sensor is housed in a particular type of package which incorporates a copper pad in its base.
- This copper pad is exposed and is designed to be soldered to the PCB to provide mechanical support. It is not involved in the normal electrical or magnetic operation of the sensor.
- The resetting field is generated by passing an electric current through this copper pad. When the current is applied, it generates a magnetic field which is, by virtue of the mechanical design of the sensor package, extremely close to the sensing element itself.

- Since the magnetic field strength around a current-carrying conductor falls off with distance, the smaller the distance between the conductor and the sensor, the smaller the current and the smaller the magnetic field is required to effectively 'reset' the sensor.
- Keeping the 'resetting' current to minimum results in improved power consumption, heating and electromagnetic interference, among other benefits.
- To generate an equivalent magnetic field at the sensing element using the same current flowing in traces under the sensor package would typically require multiple traces in parallel, in order to compensate for the increased distance between the traces and the sensing element. This increases PCB complexity and board area.

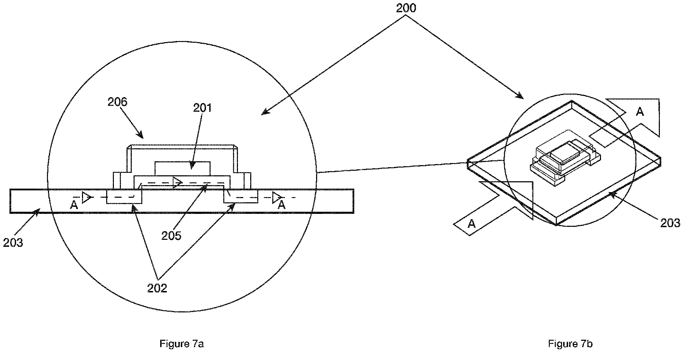

Figure 7A is a sectional view of an exemplary physical layout of the magnetic position sensor 200 (also referred to as a "reset assembly"). Figure 7B is a perspective view of the magnetic position sensor 200. The sensor comprises a semiconductor die 201 which is bonded to a copper base 205 and encapsulated in a package 206, for example a plastic package 206. The copper base 205 is soldered to a pair of pads 202 (e.g. PCB pads) on a printed circuit board 203. When the pulsed reset magnetic field is activated, current flows from one pad 202 through the copper base 205 into the other pad 202, as shown by the arrows A in Figures 7A and 4B. Thus the reset current flows in very close proximity to the sensor die 201 and the die 201 experiences a strong magnetic field.

## Claims

1. A method of sensing a magnetic field of a magnet located at a first position using a magnetic position sensor, comprising the steps off:
• Subjecting said magnetic position sensor to a pulsed reset magnetic field to align the magnetic field of the sensor to a pre-set value and orientation;
• Providing an indication of said magnetic field of the magnet when said reset magnetic field was not present; and
• Providing an indication of said first position; wherein said magnetic field of a magnet is strong relative to the minimum magnetic field strength which facilitates the accurate sensing of said magnetic field from a magnet.

2. A method according to claim 1, further comprising the step of providing an indication of a second position; wherein said magnetic field of a magnet is weak or not present relative to the minimum magnetic field strength which facilitates the accurate sensing of said magnetic field from a magnet.

3. A method according to claim 1 or claim 2, further comprising the step of providing an indication of said reset magnetic field when said reset magnetic field is present; wherein said sensor senses a combined magnetic field comprising said magnetic field from a magnet and said reset magnetic field.

4. An apparatus for sensing a magnetic field of a magnet located at a first position via a magnetic position sensor comprising said reset magnetic field which operates in accordance with claims 1 to 3; wherein said reset magnetic field is provided by communicating a pulsed electrical current to an electromagnetic means; whereby said electromagnetic means is in proximity to said magnetic position sensor.

5. An apparatus according to claim 4, wherein said reset magnetic field is provided by a time discontinuous electrical current to said electromagnetic means.

6. An apparatus according to claim 4 or claim 5, wherein said one or more conductive elements are arranged in proximity to said sensor.

7. An apparatus according to claim 6, wherein said conductive elements are arranged on and/or within a printed circuit board.

8. A magnetic position sensor comprising :
• a sensing means for sensing a magnetic field of a magnet located at a first position, wherein
• said sensing means is suitable for sensing a pulsed reset magnetic field not originating from said magnet; and
an indicating means for providing an indication of said magnetic field of the magnet when said reset magnetic field was not present,
wherein said indicating means is suitable for providing an indication of said reset magnetic field when said reset magnetic field is present; wherein said magnetic sensor senses a combined magnetic field comprising said magnetic field from the magnet and said reset magnetic field.

9. A sensor according to claim 8, further comprising a means of providing one or more measurement cycles, whereby in use, a measurement cycle comprises said sensing of the reset magnetic field which is arranged subsequent to said indication of said magnetic field of the magnet, which in use, facilitates a resetting of said indication of said magnetic field from said magnet of said measurement cycle.

10. A sensor according to claims 8 or claim 9, further comprising a metallic pad, which in use communicates a pulsed reset electrical current and thereby generating a pulsed reset magnetic field.
